# EUROPEAN PATENT SPECIFICATION

(11) **EP 4 503 033 B1**
(45) Date of publication and mention of the grant of the patent: **28.01.2026**
(21) Application number: 23189234.0
(22) Date of filing: 02.08.2023
(51) Int. Cl.: H10B 61/00, G11C 11/16, G11C 11/18, G11C 19/08

(54) **HIGH DENSITY 3D MAGNETIC MEMORY DEVICE, METHOD OF OPERATING AND METHOD OF FABRICATING THE SAME**
HOCHDICHTE 3D-MAGNETSPEICHERVORRICHTUNG, ZUGEHÖRIGES BETRIEBS- UND HERSTELLUNGSVERFAHREN
DISPOSITIF DE MÉMOIRE MAGNÉTIQUE 3D À HAUTE DENSITÉ, SON PROCÉDÉ DE FONCTIONNEMENT ET SA FABRICATION

(43) Date of publication of application: 05.02.2025
(73) Proprietor: Imec VZW, 3001 Leuven (BE)
(72) Inventor: Couet, Sebastien, 1390 Grez-Doiceau (BE); Rao, Siddharth, 3020 Herent (BE); Crotti, Davide Francesco, 3001 Heverlee (BE)
(74) Representative: Roth, Sebastian

(56) References cited:
- US-A1- 2020 303 624
- US-A1- 2021 125 653
- US-A1- 2021 295 889

## Description

### TECHNICAL FIELD

The present disclosure relates to magnetic memory devices. In particular, the present disclosure presents a new kind of magnetic memory device that may achieve a high memory density (bit density). The magnetic memory device of this disclosure is based on a spin orbit torque (SOT) magnetic random access memory (MRAM) device architecture.

### BACKGROUND

In the complex landscape of today's micro-electronics, various memory technologies are employed to meet system-level speed and density needs. For instance, fast on-chip static random access memory (SRAM) is typically placed near a central processing unit (CPU), due to its high operating speed, even though its areal density is very limited. Dynamic random access memory (DRAM) is used as a denser, yet slower, volatile working memory. Further down the hierarchy, 3D-NAND memory finds application in solid state drives (SSDs) and similar media, providing high-capacity storage affordably, but with slower read and write speeds. Over the last decade, several new memory technologies have competed for a spot in various levels of the memory pyramid. For example, spin transfer torque (STT) MRAM is one such technology. STT-MRAM is a type of resistive memory that utilizes a magnetic tunnel junction (MTJ) to encode data in the magnetic orientation of a free layer relative to a reference layer having a fixed orientation. The tunnel magnetoresistance (TMR) effect provides different resistance states depending on whether the magnetizations of the free layer and reference layer are aligned in a parallel or antiparallel.

STT-MRAM is seen as an embedded memory (built on the same die as logic), because of its relatively fast operation speeds (down to a few nanoseconds), robust endurance, and compatibility with advanced complementary metal-oxide semiconductor (CMOS) voltages. It also offers non-volatility by storing bits in a magnetic state, and therefore presents an improvement in leakage power compared to alternatives in SRAM and DRAM.

Various flavors of magnetic memories exist, with STT-MRAM being the most advanced, but SOT-MRAM and voltage controlled MRAM being potential next generation candidates with possibilities for faster speeds and/or lower power operation. Nevertheless, all of these magnetic memories are based on the MTJ technology. Since the MRAM stack itself is a complex collection of over 20 individual ultra-thin layers, the use of physical vapor deposition (PVD) is needed which implies a planar implementation.

While the MRAM technologies described above make good candidates for SRAM replacement or on-chip memory, said planar configuration ultimately limits the achievable memory density, thus limiting their application to embedded memory technology where the current density offering is limited. To target other parts of the memory pyramid, MRAM would have to exploit the third dimension, in order to potentially increase the memory density by a factor of about 100, while ideally preserving and controlling the known advantages of MRAM regarding speed and endurance.

US 2020/0303624 A1 describes a 3D MRAM architecture comprising a multilayer stack with two different thin insulating layers enabling selective etching to form a channel with recesses and protrusions; a magnetic channel material to store magnetic informations in domains, which are pinned at the recess and/or protrusion; an MTJ as reading unit and a terminal as writing unit. An SOT layer is used to improve the movement of the domain walls at a distance to the MTJ.

US 2021/0295889 A1 describes a 3D MRAM device comprising a magnetic unit for magnetic domains. The corresponding domain walls are confined at recesses of a multilayer stack. An MTJ is used for reading the magnetic information.

US 2021/0125653 A1 describes a 3D SOT-MRAM architecture with a closed loop unit for race track memory storage. The magnetic information is written by an SOT and an MTJ unit.

### SUMMARY

In view of the above, the present disclosure aims to provide a new kind of magnetic memory device that is based on MRAM. An objective is, in particular, to exploit all three dimensions. i.e., to depart from the planar configuration. An ultimate objective is thereby to significantly increase the achievable memory density for storing more information in the magnetic memory device.

These and other objectives are achieved by the solutions described in the independent claims. Advantageous implementations are described in the dependent claims.

A first aspect of this invention provides a 3D magnetic memory device, the magnetic memory device comprising: a stack comprising a plurality of dielectric layers and silicon-based layers, which are alternatingly arranged one on the other; a magnetic material channel formed through the stack, wherein the magnetic material channel extends through each layer of the stack, wherein the magnetic material channel has a first diameter where it extends through a silicon-based layer and a second diameter where it extends through a dielectric layer of the stack, and wherein a plurality of pinning sites defined by the plurality of layers of the stack is formed in the magnetic material channel, each pinning site being configured to store one magnetic bit; a first metallic layer arranged on a first end of the magnetic material channel and on the last layer of the stack; a magnetic tunnel junction, MTJ, arranged on the first metallic layer; and a first electrode arranged on the first metallic layer at a distance to the MTJ; wherein either the first metallic layer is configured as a spin-orbit-torque, SOT, track, or the magnetic memory device comprises a second metallic layer configured as a SOT track and a second end of the magnetic material channel and the first layer of the stack are arranged on the second metallic layer.

The magnetic material channel may be a memory cell of the magnetic memory device of the first aspect. The magnetic memory device may comprise multiple such magnetic material channels formed in multiples stacks in the same way as described above, in order to implement multiple memory cells of the magnetic memory device. The multiple magnetic material channels may thereby be arranged in parallel to each other and/or may be arranged in an array of magnetic material channels, for instance, an array comprising a plurality of rows and columns. That is, the channels may be arranged in a 2D array and may extend along the third dimension. Thus, the 3D magnetic memory device of the first aspect can exploit all three dimensions, and depart from the usual planar configurations. Consequently, the magnetic memory device of the first aspect may have a significantly increased memory density, and can store more information that a conventional, planar magnetic memory device.

Furthermore, the magnetic memory device of the first aspect can employ SOT for writing information into the magnetic material channel of the memory cell, and can employ TMR using the MTJ to read out information from the magnetic material channel of the memory cell. Moreover, information can be moved in the magnetic material channel by a push current, and thus moving magnetic bits stored in the magnetic material channel from one pinning site to the next.

The pinning sites are enabled by the periodicity of the layer stack and are able to stabilize a magnetic domain within a single layer height. Hence, the height of a magnetic bit can be defined by the periodicity.

In an implementation, the 3D magnetic memory device further comprises a second electrode arranged on or directly below a second end of the magnetic material channel.

The second electrode facilitates sending a push current through the magnetic material channel towards the first electrode.

In an implementation of the 3D magnetic memory device, the first diameter is larger than the second diameter.

This may allow adjusting the pinning strength in the respective pinning sites of the magnetic material channel. Thus, also the performance of the magnetic memory device, for instance, regarding its retention and latency, can be tailored.

In an implementation of the 3D magnetic memory device, a ratio between the first diameter and the second diameter is in a range of 1.1:1 to 2:1.

A smaller ratio may be used to favor latency, while a larger ratio may be used to favor retention time of the magnetic memory device.

In an implementation of the 3D magnetic memory device, a thickness of the silicon-based layers and the dielectric layers is respectively in range of 5-150 nm.

In an implementation of the 3D magnetic memory device, transitions between the first diameter and the second diameter are aligned with interfaces between the alternatingly arranged layers of the stack.

In an implementation of the 3D magnetic memory device: the dielectric layers are silicon oxide layers and the silicon-based layers are silicon nitride layers; or the dielectric layers are silicon layers and the silicon-based layers are silicon germanium layers.

In an implementation of the 3D magnetic memory device, the magnetic material channel is made of a ferromagnetic or ferrimagnetic material, for example, is made of cobalt, iron, nickel, or an alloy thereof, or any of the former in addition to boron.

In an implementation of the 3D magnetic memory device, at least one of the first metallic layer and the second metallic layer is made of tantalum nitride, tungsten nitride, tungsten, tantalum, platinum, hafnium, molybdenum, molybdenum nitride, or alloys thereof, or is made of a topological insulator.

These materials may allow using either the first metallic layer or the second metallic layer as an SOT track, i.e., sending an SOT current through the layer to write a magnetic bit into the magnetic material channel of the memory cell.

In an implementation of the 3D magnetic memory device, the MTJ is arranged directly above the first end of the magnetic material channel on the first metallic layer, or is arranged offset from the first end of the magnetic material channel.

In an implementation of the 3D magnetic memory device, the MTJ comprises a magnetic free layer having a coercivity of equal to or less than 20-40 mT, or a coercivity in a range of 2-3 mT.

This, the stray magnetic field of the pinning site closest to the MTJ may determine the orientation of the free layer.

A second aspect of this invention provides a method of operating the 3D magnetic memory device of the first aspect or any implementation thereof, wherein the method comprises at least one of the following operations: writing a magnetic bit into the magnetic material channel by passing a current through the SOT track, wherein the magnetic bit is written into the pinning site in the magnetic material channel that is closest to the SOT track; pushing magnetic bits along the magnetic material channel from one pinning site to the next pinning site by passing a current through the first electrode; reading a magnetic bit from the magnetic material channel by passing a current through the MTJ and thereby determining a tunnel-magnetoresistance, wherein the magnetic bit stored in the pinning site in the magnetic material channel that is closest to the MTJ is read.

The method of the second aspect provide allows to perform a write operation, a read operation, or a push operation, with the magnetic memory device of the first aspect, particularly, in the memory cell of the magnetic memory device comprising the magnetic material channel. Similar operations can be performed, subsequently or in parallel, on different memory cells of the magnetic memory device.

In an implementation of the method, the magnetic memory device comprises the second electrode, and pushing the magnetic bits comprises sending the current from the second electrode to the first electrode; or the magnetic memory device does not comprise the second electrode but comprises the second metallic layer, and pushing the magnetic bits comprises sending the current from the second metallic layer to the first electrode; or the magnetic memory device comprises the second electrode and the first metallic layer is configured as the SOT track, and pushing the magnetic bits comprises sending a bi-polar current from the second metallic layer to the first electrode.

The above implementation provides different ways of performing the push operation with the magnetic memory device of the first aspect.

In an implementation of the method, when pushing the magnetic bits stored in the magnetic material channel, the magnetic bit stored in the pinning site in the magnetic material channel that is closest to the first metallic layer is destructed, and the method further comprises: re-writing the destructed magnetic bit into the magnetic material channel or storing the information corresponding to the destructed magnetic bit in a memory.

A third aspect of this invention provides a method of fabricating a 3D magnetic memory device, the method comprising: forming a stack of a plurality of dielectric layers and silicon-based layers, which are alternatingly arranged one on the other; forming a hole through the stack, wherein the hole extends through the layers of the stack; selectively etching from within the hole, in order to recess either the dielectric layers or the silicon-based layer so as to partially broaden the hole; filling a magnetic material into the etched hole to form a magnetic material channel, which has a first diameter where it extends through a silicon-based layer of the stack and a second diameter where it extends through a dielectric layer of the stack, wherein a plurality of stacked pinning sites defined by the plurality of layers of the stack is formed in the magnetic material channel, each pinning site being configured to store one magnetic bit; forming a first metallic layer on a first end of the magnetic material channel and on the last layer of the stack; forming a magnetic tunnel junction, MTJ, on the first metallic layer; and forming a first electrode on the first metallic layer at a distance to the MTJ; wherein either the first metallic layer is configured as a spin-orbit-torque, SOT, track, or the method further comprises forming a second metallic layer configured as a SOT track and arranging a second end of the magnetic material channel and the first layer of the stack on the second metallic layer.

In an implementation, the method further comprises depositing a liner of SOT track material on the walls of the hole, before filling the magnetic material into the hole.

The methods of the third aspect may lead to the same advantages as described above for the magnetic memory device of the first aspect. The method of the third aspect may be extended by respective implementations as described above for the magnetic memory device of the first aspect.

### BRIEF DESCRIPTION OF THE DRAWINGS

The above described aspects and implementations are explained in the following description of embodiments with respect to the enclosed drawings:
- FIG. 1: shows an example of a magnetic memory device according to this disclosure with a top SOT track.
- FIG. 2: shows another example of a magnetic memory device according to this disclosure with a bottom SOT track.
- FIG. 3: shows another example of a magnetic memory device according to this disclosure with an out-of-plane MTJ.
- FIG. 4: shows another example of a magnetic memory device according to this disclosure with a bottom electrode.
- FIG. 5: shows another example of a magnetic memory device according to this disclosure without the bottom electrode but with a further top electrode.
- FIG. 6: shows an example of writing a magnetic bit into a magnetic memory device according to this disclosure.
- FIG. 7: shows an example of pushing magnetic bits in a magnetic memory device according to this disclosure.
- FIG. 8: shows a method of operating a magnetic memory device according to this disclosure.
- FIG. 9: shows a method of fabricating a magnetic memory device according to this disclosure.
- FIG. 10: shows examples of recessed channels and layer stack heights, in order to control retention and latency for different performance specifications.
- Fig. 11: another example of a magnetic memory device according to this disclosure with a SOT liner.

### DETAILED DESCRIPTION OF EMBODIMENTS

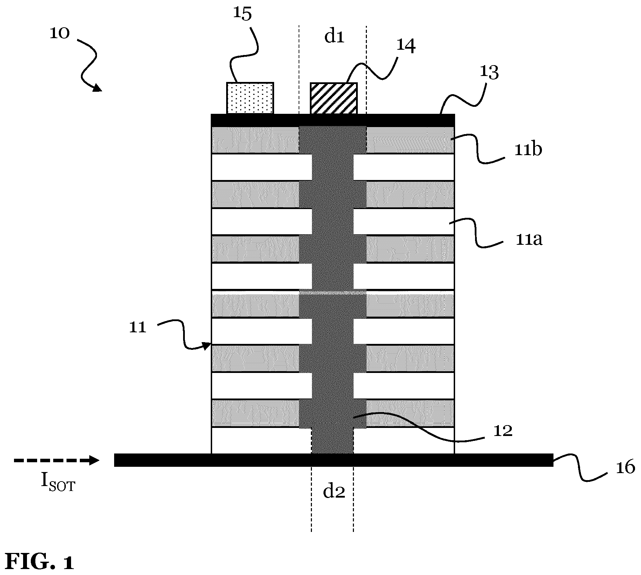

FIG. 1 shows an example of a 3D magnetic memory device 10 according to this disclosure.

Like all examples of memory devices 10 presented in this disclosure, the magnetic memory device 10 of FIG. 1 comprises a layer stack 11, which comprising a plurality of dielectric layers 11a and silicon-based layers 11b, which are alternatingly arranged one on the other. Through this stack 11 a magnetic material channel 12 is formed. The magnetic material channel 12 extends through each layer 11a, 11b of the stack 11. The magnetic material channel 12 may extend along a first direction, which corresponds to a stacking direction of the layers 11a, 11b of the stack 11. This first direction may be referred to as 'vertical direction', as oriented in FIG. 1. The magnetic material channel 12 may thus extend perpendicular to the surfaces of the layers of the stack 11. However, it is also possible that the magnetic material channel 12 extends in a slight angle to the surfaces of the layers 11a, 11b.

As can be further seen in FIG. 1, and is common to all examples of magnetic memory devices 10 presented in this disclosure, the magnetic material channel 12 has a first diameter d1 where it extends through a silicon-based layer 11b, and has a second diameter d2 where it extends through a dielectric layer 11a of the stack 11. That is, the at least one magnetic material channel 12 has a varying diameter. This may be caused by partly recessing either the silicon-based layers 11b or the dielectric layers 11a of the stack 11 during the fabrication of the memory device 10, before forming the magnetic material channel 12. For example, the first diameter may be larger than the second diameter as shown in FIG. 1, but this can also be the other way around.

Due to the alternation of the layers 11a, 11b of the stack 11, and further enhanced by the varying diameter of the magnetic material channel 12, a plurality of pinning sites, defined by the plurality of layers 11a, 11b of the stack, are formed in the magnetic material channel 12. Each of these pinning sites is configured to store one magnetic bit. It may be beneficial for the pinning sites, that the transitions between the first diameter d1 and the second diameter d2 are aligned with interfaces between the alternatingly arranged layers 11a, 11b of the stack 11.

The magnetic memory device 10 of each example in this disclosure, as is shown in FIG. 1, further comprises a first metallic layer 13, which is arranged on a first end of the magnetic material channel 12 and on the last layer of the stack 11. The 'last layer' relates to the arrangement of the layers along the stacking direction of the layers 11a, 11b during the fabricating the stack 11, from a first layer of the stack to the last layer of the stack 11. On the first metallic layer 13, a MTJ 14 is arranged. In addition, a first electrode 15 (also referred to as 'top electrode') is arranged on the first metallic layer 13 at a distance to the MTJ 14. The MTJ 14 comprises at least a free layer, a reference layer, and a tunnel barrier layer, so that it enables measuring TMR as known from conventional MRAM. Advantageously, the MTJ 14 may comprises a magnetic free layer having a coercivity of equal to or less than 20-40 mT, or in a range of 2-3 mT.

As shown for the example of FIG. 1, the MTJ 14 may be arranged directly above the first end of the magnetic material channel 12 on the first metallic layer 13.

As also shown for the example of FIG. 1, the magnetic memory device 10 may comprise a second metallic layer 16, which is configured as an SOT track. The second end of the magnetic material channel 12 and the first layer of the stack 11 are arranged on the second metallic layer 16 in this case. Being configured as an SOT track means that the second metallic layer 16 may be made of a certain material, have a certain thickness, and may be connected to suitable electrodes, in order to allow passing an SOT current (I_{SOT}) through the second metallic layer 16, which causes a magnetic bit to be written by SOT into the pinning site defined by the layer of the stack 11 that is closest to the second metallic layer 16, as will be explained later.

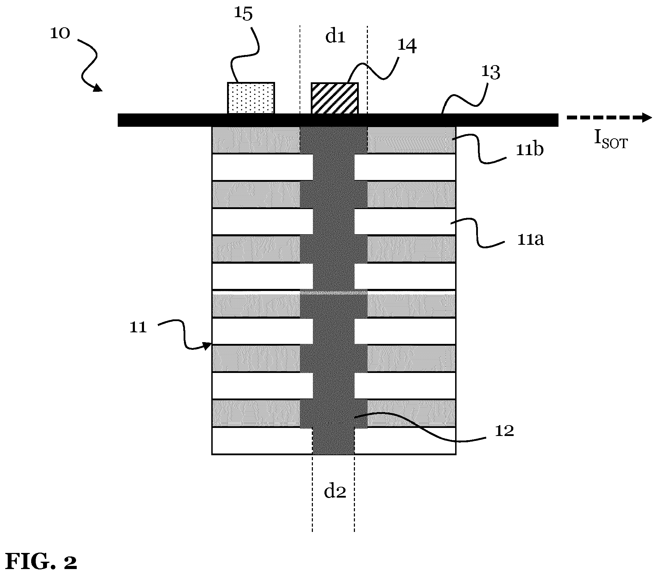

FIG. 2 shows another example of a 3D magnetic memory device 10 according to this disclosure. Same elements of the memory devices 10 in FIG. 1 and FIG. 2 share the same reference signs.

As shown for the example of FIG. 2, instead of comprising the second metallic layer 16 like the magnetic memory device of FIG. 1, the first metallic layer 13 may be configured as a SOT track. That is, the first metallic layer 13 may be made of a certain material, have a certain thickness, and may be connected to suitable electrodes, to allow passing an SOT current I_{SOT} through the layer 13, which causes a magnetic bit to be written by SOT into the pinning site defined by the layer of the stack 11 that is closest to the first metallic layer 13.

At least one of the first metallic layer 13 and the second metallic layer 16, particularly at least the metallic layer 13, 16 that is configured as the SOT track, may be made of tantalum nitride, tungsten nitride, tungsten, tantalum, platinum, hafnium, molybdenum, molybdenum nitride, or alloys thereof, or of a topological insulator.

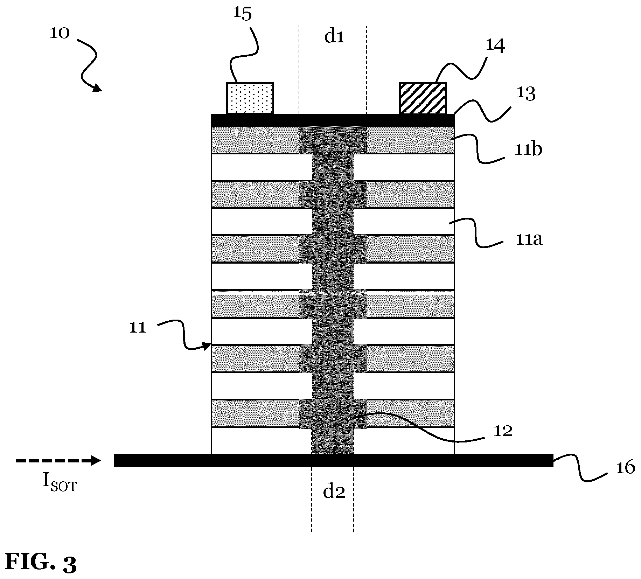

FIG. 3 shows another example of a 3D magnetic memory device 10 according to this disclosure. Same elements of the memory devices 10 in FIG. 3 and in the previous figures share the same reference signs.

As show for the example of FIG. 3, the MTJ 14 may also be arranged offset from the first end of the magnetic material channel, i.e., is in this case not positioned directly above said first end of the channel 12. The MTJ 14 may thus be either closer to or further away from the first electrode 15 as in the first and second examples shown in FIGs. 1 and 2. The MTJ 14 is also referred to as being arranged out-of-plane in this case.

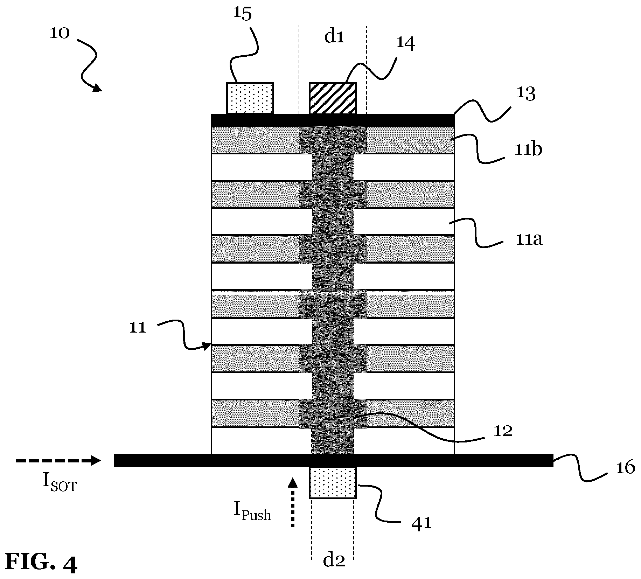

FIG. 4 shows another example of a 3D magnetic memory device 10 according to this disclosure. Same elements of the memory devices 10 shown in FIG. 4 and the previous figures share the same reference signs. The example of FIG. 4 builds particularly on the example of FIG. 1, but the following features are also applicable to the magnetic memory devices 10 of the examples of FIGs. 2 and 3.

As shown for the example of FIG. 4, the magnetic memory device 10 may comprise a second electrode 41 (Also referred to as 'bottom electrode'), which is arranged on or directly below a second end of the magnetic material channel 12. The second electrode 41 may be placed on the second metallic layer 16, as shown. However, in the absence of the second metallic layer 16, like in the example of FIG. 2, the second electrode 41 could be placed directly on the second end of the magnetic material channel 12 and the first layer of the stack 11. The second electrode 41 may allow sending a push current I_{Push} into the magnetic material channel 12 and towards the first electrode 15.

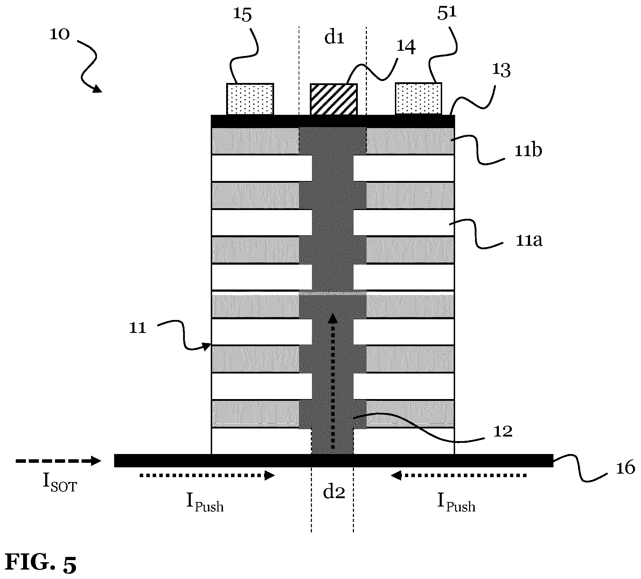

FIG. 5 shows another example of a 3D magnetic memory device 10 according to this disclosure. Same elements of the memory devices 10 shown in FIG. 5 and the previous figures share the same reference signs. The example of FIG. 4 builds particularly on the example of FIG. 1.

As shown for the example of FIG. 5, the magnetic memory device 10 may comprise a further first electrode 51 (also referred to as 'further top electrode'). Further, the magnetic memory device 10 may comprise no second electrode 41 at the bottom, as in FIG. 4. Without the second electrode 41, a more compact memory cell of the memory device 10 may be obtained, which may lead to a smaller footprint of the memory device 10 comprising multiple such memory cells. In the example of FIG. 5, the push current I_{Push} may be provided by sending current through both sides of the SOT track provided by the second metallic layer 16. In particular, the current is pushed from both sides to limit the current density in the second metallic layer 16, and to increase its endurance and reliability.

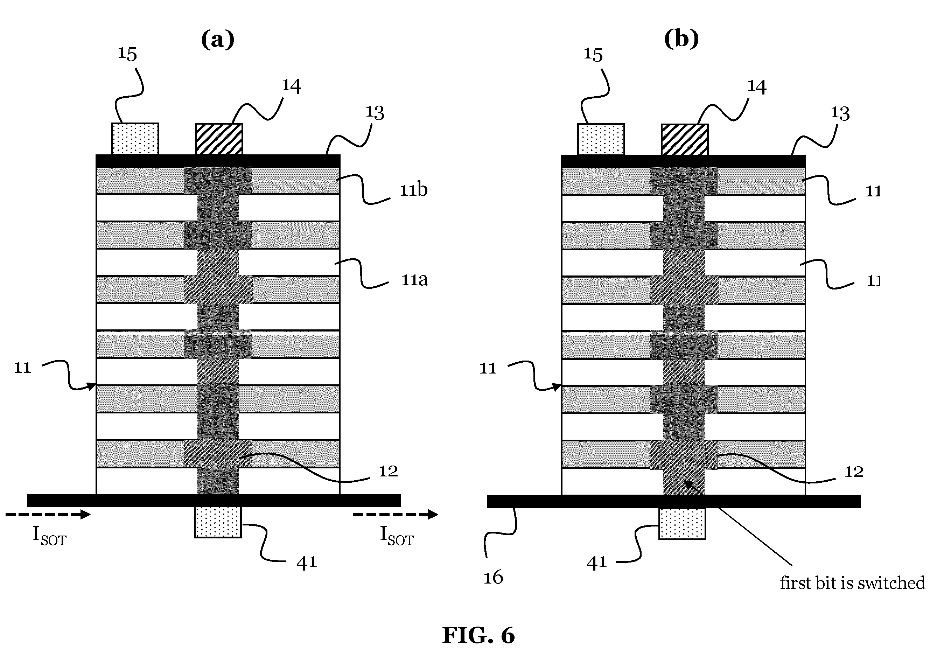

FIG. 6 shows an example of writing a magnetic bit into a magnetic memory device 10 according to this disclosure. FIG. 6 shows in particular the example of FIG. 4 for demonstrating the writing operation. FIG. 6(a) shows the magnetic memory device 10 before/during the writing operation, while FIG. 6(b) shows the magnetic memory device 10 after the writing operation.

The writing of the magnetic bit into the magnetic material channel 12 is caused by passing the current I_{SOT} through the second metallic layer 16, which is configured as the SOT track. The magnetic bit is written into the pinning site in the magnetic material channel 12, which is closest to the SOT track, i.e., the pinning site corresponding to the first layer of the channel 12. A positive or negative current I_{SOT} will determine the writing of the magnetic bit as 'up' or 'down' (for the case of perpendicular magnetization) or 'left' or 'right' (for the case of in-plane magnetization). For instance, in FIG. 6(b), the writing of the magnetic bit has resulted in a switching of the bit, i.e., a switching of the magnetization in the corresponding pinning site.

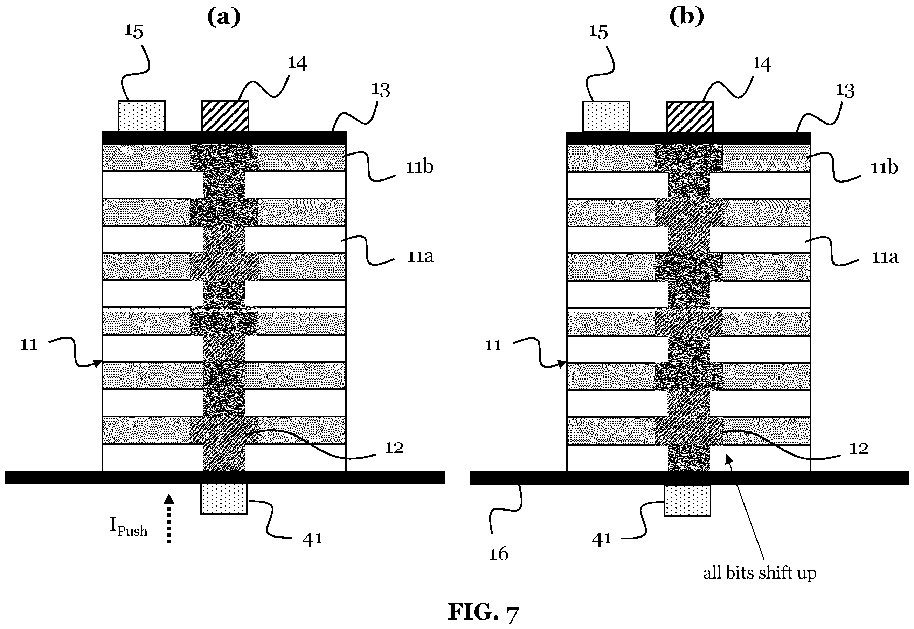

FIG. 7 shows an example of pushing magnetic bits in a magnetic memory device 10 according to this disclosure. FIG. 7 shows in particular the example of FIG. 4 for demonstrating the pushing operation, following the writing operation shown in FIG. 6. The pushing of the magnetic bits moves the magnetic bits along the magnetic material channel 12 from one pinning site to the next pinning site. As the example of FIG. 4 is used, magnetic bits are pushed upwards in the magnetic material channel 12 in FIG. 7, i.e., towards the MTJ 14.

The magnetic bits are pushed by passing a current I_{Push} through the first electrode 15. In FIG. 7, the current is sent into the second electrode 41 towards the first electrode 15. If there would be no second electrode 41, the current I_{Push} could be sent towards the first electrode 15 as illustrated in FIG. 5, namely using the second metallic layer 16. During the pushing operation, a pulse timing may beneficially coincide with a domain wall movement of one period (one pinning site). The push current I_{Push} will shift all magnetic bits (pinned magnetic domains) upwards by one pinning site. At the top of the magnetic channel 12 in FIG. 7, the surface of the first end of the magnetic material channel 12 is advantageously flat, e.g., it may be flattened by chemical mechanic polishing (CMP). The first metallic layer 13 may function as a thin metallic spacer layer in this case (wherein it could be made of TaN), in order to provide a path for the current to go to the first electrode 15.

For reading a magnetic bit, the magnetic state of the uppermost magnetic bit may be sensed in the magnetic memory device 10 according to the example of FIG. 4. This can be done by using the top-pinned MTJ 14. The free layer of the MTJ 14 may be deposited in direct contact with the first metallic layer 13. The free layer may have the above-mentioned low coercivity of 40 mT or less, such that the stray magnetic field of the top magnetic bit (e.g., 'up' or 'down', higher than the free layer coercivity) may determine the orientation of the free layer. The actual sensing can then be done by reading the resistance of the MTJ 14 and the TMR effect.

Since, in this example, the magnetic bit reaching the top of the magnetic channel 12 - which may be read using the MTJ 14 - will be annihilated at the next push, the read operation of the magnetic memory device 10 may be a destructive read. The magnetic bit may then either be re-written at the bottom of the magnetic material channel 12, i.e., at the SOT track, or may be stored in a buffer memory, for instance, for a later burst write.

The magnetic memory device 10 may, for example, operate in a 'full string' writing and/or reading mode. This means that the smallest addressable bit-length may be equal to the number of bilayers 11a/11b in the stack 11. However, the operation mode of the magnetic memory device 10 may also be determined by architectural choices on the array and system level.

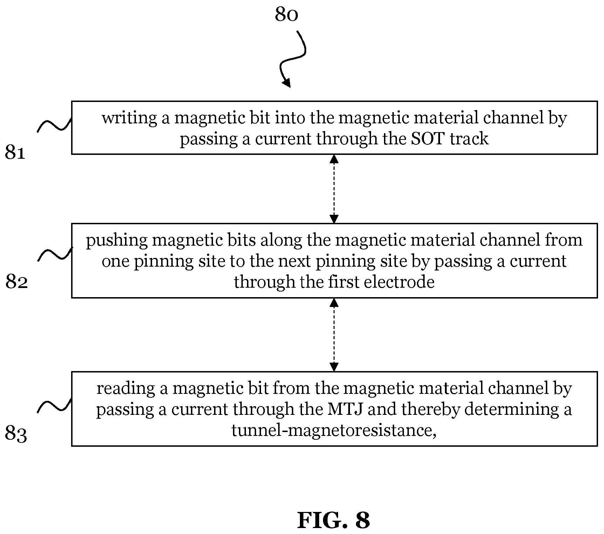

FIG. 8 shows a method 80 of operating the 3D magnetic memory device 10, which summarizes generally the above-described. The method comprises at least one of the following operations: an operation 81 of writing a magnetic bit into the magnetic material channel 12 by passing a current through the SOT track, wherein the magnetic bit is written into the pinning site in the magnetic material channel that is closest to the SOT track; an operation 82 of pushing magnetic bits along the magnetic material channel 12 from one pinning site to the next pinning site by passing a current through the first electrode 15; an operation 83 of reading a magnetic bit from the magnetic material channel 12 by passing a current through the MTJ 14 and thereby determining a TMR, wherein the magnetic bit stored in the pinning site in the magnetic material channel 12 that is closest to the MTJ 14 is read.

If the magnetic memory device 10 comprises the second electrode 41 (like in FIG. 4), the pushing of the magnetic bits may comprise sending the current I_{Push} from the second electrode 41 to the first electrode 15. If the magnetic memory device 10 does not comprise the second electrode 41, but comprises the second metallic layer 16 as the SOT track (like in FIG. 5), pushing the magnetic bits may comprise sending the current I_{Push} from the second metallic layer 16 to the first electrode 15. If the magnetic memory device 10 comprises the second electrode 41 and the first metallic layer 13 is configured as the SOT track (like in FIG. 2 but with the second electrode 41 arranged beneath the second end of the magnetic material channel 12), pushing the magnetic bits may comprise sending a bi-polar current from the second metallic layer 16 to the first electrode 15.

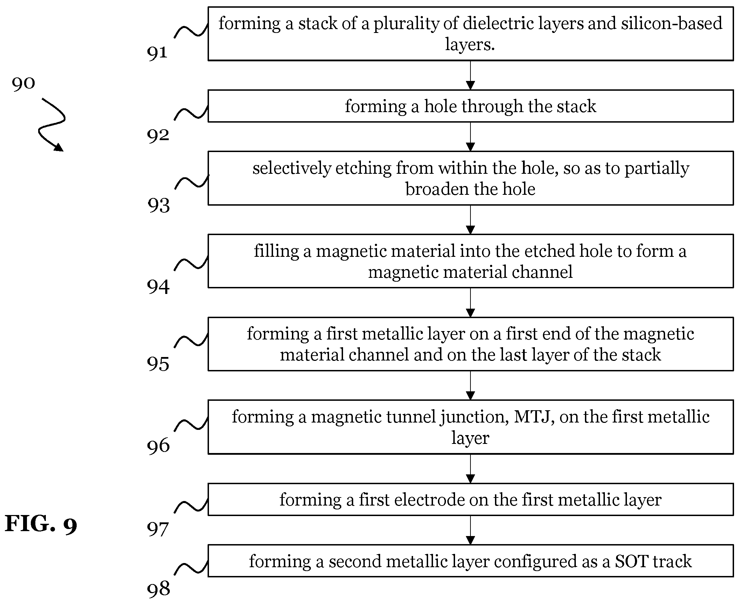

FIG. 9 shows a method 90 of this disclosure of fabricating the 3D magnetic memory device 10. The method 90 comprise a step 91 of forming the stack 11 of a plurality of dielectric layers 11a and silicon-based layers 11b, which are alternatingly arranged one on the other. The method 90 further comprises a step 92 of forming a hole through the stack 11, wherein the hole extends through the layers 11a, 11b of the stack 11. The method 90 then comprises a step 93 of selectively etching from within the hole, in order to recess either the dielectric layers 11a or the silicon-based layers 11b, so as to partially broaden the hole. The method 90 then comprises a step 94 of filling a magnetic material into the etched hole to form the magnetic material channel 12, which has the first diameter d1 where it extends through a silicon-based layer 11b of the stack and the second diameter d2 where it extends through a dielectric layer 11a of the stack 11.

The method 90 further comprises a step 95 of forming the first metallic layer 13 on the first end of the magnetic material channel 12 and on the last layer of the stack 11, and a step 96 of forming the MTJ 14 on the first metallic layer 13. Then, the method further comprises a step 97 of forming the first electrode 15 on the first metallic layer 13 at a distance to the MTJ 14.

If the magnetic memory device 10 comprises the first metallic layer 13 as SOT track (like in FIG. 2), the method 90 may be complete at this point. Alternatively, the method 90 may further comprise a step 97 of forming a second metallic layer 16 configured as a SOT track (as in FIG. 1) and arranging the second end of the magnetic material channel 12 and the first layer of the stack 11 on the second metallic layer 16.

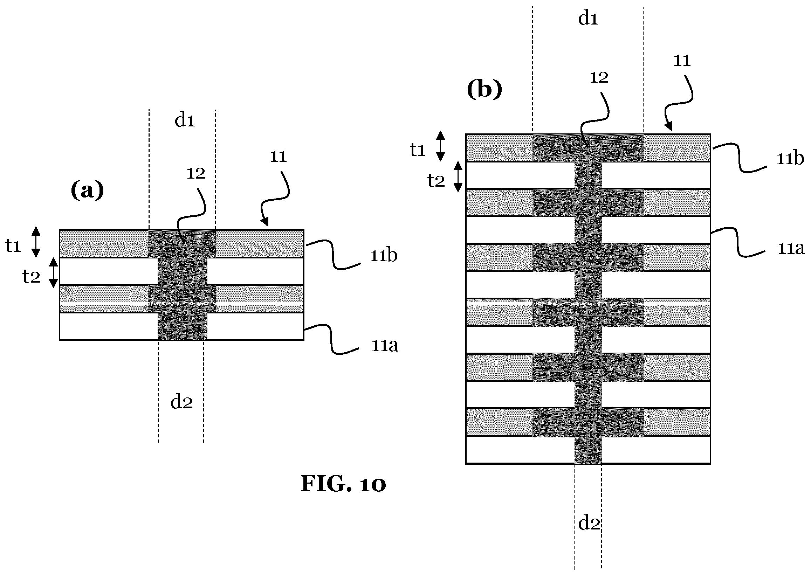

FIG. 10 shows examples of differently recessed magnetic material channels 12 and layer stack heights, which can be applied in any example of the magnetic memory device 10 of this disclosure. The various configurations may allow controlling a retention time and a latency of the magnetic memory device 10, which may be useful for complying with different performance specifications. In the example of FIG. 10, the first diameter d1 is larger than the second diameter d2.

Generally, a ratio between the first diameter d1 and the second diameter d2 may be in a range of 1.1:1 to 2:1. The transitions between the first diameter d1 and the second diameter d2 are advantageously aligned with interfaces between the alternatingly arranged layers 11a, 11b of the stack 11. Furthermore, a thickness t1 of the silicon-based layers 11b and a thickness t2 of the dielectric layers 11a may, respectively, in range of 5-150 nm. Same layers 11a or 11b may all have the same thickness t1 or t2.

Specifically, FIG. 10(a) shows an example of the magnetic material channel recess, which reduces retention, but is beneficial for latency. The number of layers 11a, 11b of the stack 11 may be comparatively small, for example only in the order of 2-10 of each. Moreover, the recess may be comparatively small, for example, the ratio between the first diameter d1 and the second diameter d2 may be in a range of 1.1:1 to 4:3.

FIG. 10(b) shows an example of the magnetic material channel recess, which reduces latency, but is beneficial for retention, i.e., increases retention. The number of layers 11a, 11b of the stack 11 may be comparatively large, particularly larger than in FIG. 10(b), for example, in the order of 10-50 of each. Moreover, the recess may be comparatively small, particularly larger than in FIG. 10(b), for example, the ratio between the first diameter d1 and the second diameter d2 may be in a range of 3:2 to 2:1.

For example, after creating the hole in the stack 11, a selective etch can be applied to recess either layer material. This allows for controlling or adjusting the diameter of the magnetic material channel 12. This may strongly improve the domain wall movement, placement and dimension. The tuning of the recess (and hence, magnetic channel diameter variation) enables adjusting the domain pinning strength to achieve good operating window or adjust retention requirements. This also open the path for tailored performance. For example, one could imagine a limited height bit stack with low pinning to operate closer to DRAM latency and endurance, or a very tall stack with high pinning to cover 3D-NAND and archival specifications.

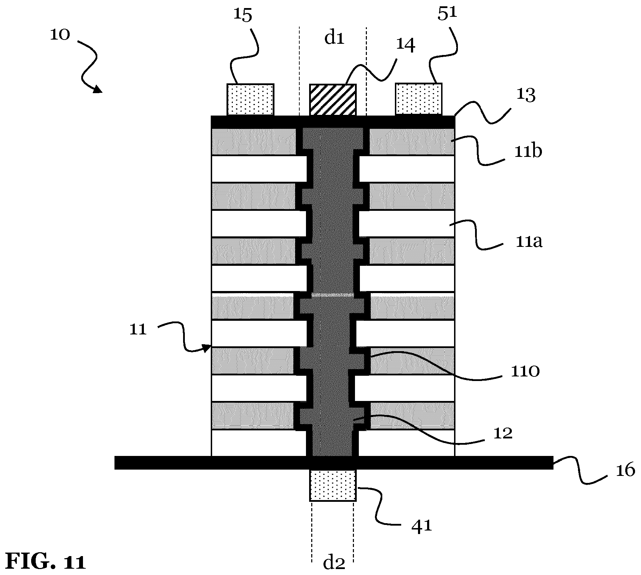

FIG. 11 shows another example of a magnetic memory device 10 according to this disclosure. Same elements of the memory devices 10 in FIG. 11 and in the previous figures share the same reference signs. The example of FIG. 11 particularly builds on the examples of FIG. 4 and 5, wherein the magnetic memory device 10 of FIG. 11 includes both the further first electrode 51 of FIG. 5 and the second electrode 41 of FIG. 4

As shown for the example of FIG. 11, the magnetic memory device 10 may comprise a liner (e.g., a sheet) of SOT track material, i.e., a SOT material liner, on the interfaces of the magnetic material channel 12 and the layers 11a, 11b. For example, the liner of SOT track material may be deposited on walls of a hole through the layer stack 11, before magnetic material is filled into the hole to form the magnetic material channel 12. The liner may increase the domain wall movement efficiency, and hence may reduce the push current I_{Push}. Ideally the liner material is the same as, or at least similar to, the material of the SOT track, for reasons of compatibility (but this is not a must).

In all examples of this disclosure, the dielectric layers 11a may be silicon oxide layers and the silicon-based layers 11b may be silicon nitride layers. Alternatively, the dielectric layers 11a may be silicon layers and the silicon-based layers may be silicon germanium layers.

In all examples of this disclosure, the magnetic material channel may be made of a ferromagnetic or ferrimagnetic material, for example, is made of cobalt, iron, nickel, or an alloy thereof, or any of the former in addition to boron.

In summary, this disclosure propose a magnetic memory device 10 that relies on a vertical arrangement of magnetic domains in a magnetic material channel 12 (e.g., a magnetic material wire) to store magnetic bits. Domain pinning (for high retention) can be achieved using the layer stack 11, for instance, providing a SiN/SiO matrix, of which the morphology can be tuned to enhance or reduce pinning. Writing magnetic bits occurs via SOT at one end of the stack. Domain wall transport may be achieved by applying a current to the magnetic material channel 12 itself, and read-out may occurs where the MTJ 14 is used to sense the magnetic stray field of the closest domain.

In the claims as well as in the description of this disclosure, the word 'comprising' does not exclude other elements or steps and the indefinite article 'a' or 'an' does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A three dimensional, 3D, magnetic memory device (10), the magnetic memory device (10) comprising:
a stack (11) comprising a plurality of dielectric layers (11a) and silicon-based layers (11b), which are alternatingly arranged one on the other;
a magnetic material channel (12) formed through the stack (11),
wherein the magnetic material channel (12) extends through each layer (11a, 11b) of the stack (11),
wherein the magnetic material channel (12) has a first diameter (d1) where it extends through a silicon-based layer (11b) and a second diameter (d2) where it extends through a dielectric layer (11a) of the stack (11), and
wherein a plurality of pinning sites defined by the plurality of layers (11a, 11b) of the stack is formed in the magnetic material channel (12), each pinning site being configured to store one magnetic bit;
a first metallic layer (13) arranged on a first end of the magnetic material channel (12) and on the last layer of the stack (11);
a magnetic tunnel junction, MTJ, (14) arranged on the first metallic layer (13); and
a first electrode (15) arranged on the first metallic layer (13) at a distance to the MTJ;
wherein either the first metallic layer (13) is configured as a spin-orbit-torque, SOT, track, or the magnetic memory device (10) comprises a second metallic layer (16) configured as an SOT track and a second end of the magnetic material channel (12) and the first layer of the stack (11) are arranged on the second metallic layer (16).

2. The 3D magnetic memory device (10) of claim 1, further comprising a second electrode (41) arranged on or directly below the second end of the magnetic material channel (12).

3. The 3D magnetic memory device (10) of claim 1 or 2, wherein the first diameter (d1) is larger than the second diameter (d2).

4. The 3D magnetic memory device (10) of one of the claims 1 to 3, wherein a ratio between the first diameter (d1) and the second diameter (d2) is in a range of 1.1:1 to 2:1.

5. The 3D magnetic memory device (10) of one of the claims 1 to 4, wherein a thickness of the silicon-based layers (11b) and the dielectric layers (11a) is respectively in range of 5-150 nm.

6. The 3D magnetic memory device (10) of one of the claims 1 to 5, wherein transitions between the first diameter (d1) and the second diameter (d2) are aligned with interfaces between the alternatingly arranged layers of the stack (11).

7. The 3D magnetic memory device (10) of one of the claims 1 to 6, wherein:
the dielectric layers (11a) are silicon oxide layers and the silicon-based layers (11b) are silicon nitride layers; or
the dielectric layers (11a) are silicon layers and the silicon-based layers (11b) are silicon germanium layers.

8. The 3D magnetic memory device (10) of one of the claims 1 to 7, wherein the magnetic material channel (12) is made of a ferromagnetic or ferrimagnetic material, for example, is made of cobalt, iron, nickel, or an alloy thereof, or any of the former in addition to boron.

9. The 3D magnetic memory device (10) of one of the claims 1 to 8, wherein at least one of the first metallic layer (13) and the second metallic layer (16) is made of tantalum nitride, tungsten nitride, tungsten, tantalum, platinum, hafnium, molybdenum, molybdenum nitride, or alloys thereof, or is made of a topological insulator.

10. The 3D magnetic memory device (10) of one of the claims 1 to 9, wherein the MTJ (14) is arranged directly above the first end of the magnetic material channel (12) on the first metallic layer (13), or is arranged offset from the first end of the magnetic material channel (12).

11. The 3D magnetic memory device (10) of one of the claims 1 to 10, wherein the MTJ (14) comprises a magnetic free layer having a coercivity of equal to or less than 20-40 mT, or a coercivity in a range of 2-3 mT.

12. A method (80) of operating the 3D magnetic memory device (10) of any one of the claims 1 to 10, wherein the method (80) comprises at least one of the following operations:
writing (81) a magnetic bit into the magnetic material channel (12) by passing a current through the SOT track, wherein the magnetic bit is written into the pinning site in the magnetic material channel (12) that is closest to the SOT track;
pushing (82) magnetic bits along the magnetic material channel (12) from one pinning site to the next pinning site by passing a current through the first electrode (15);
reading (83) a magnetic bit from the magnetic material channel (12) by passing a current through the MTJ (14) and thereby determining a tunnel-magnetoresistance, wherein the magnetic bit stored in the pinning site in the magnetic material channel (12) that is closest to the MTJ (14) is read.

13. The method (80) of claim 12, wherein:
the magnetic memory device (10) comprises the second electrode (41), and pushing the magnetic bits comprises sending the current from the second electrode (41) to the first electrode (15); or
the magnetic memory device (10) does not comprise the second electrode (41) but comprises the second metallic layer (16), and pushing (82) the magnetic bits comprises sending the current from the second metallic layer (16) to the first electrode (15); or
the magnetic memory device (10) comprises the second electrode (41) and the first metallic layer (13) is configured as the SOT track, and pushing (82) the magnetic bits comprises sending a bi-polar current from the second metallic layer (16) to the first electrode (15).

14. The method (80) of claim 12 or 13, wherein when pushing (82) the magnetic bits stored in the magnetic material channel (12), the magnetic bit stored in the pinning site in the magnetic material channel (12) that is closest to the first metallic layer (13) is destructed, and the method (80) further comprises:
re-writing the destructed magnetic bit into the magnetic material channel (12) or storing the information corresponding to the destructed magnetic bit in a memory.

15. A method (90) of fabricating a 3D magnetic memory device (10), the method (90) comprising:
forming (91) a stack (11) of a plurality of dielectric layers (11a) and silicon-based layers (11b), which are alternatingly arranged one on the other;
forming (92) a hole through the stack (11), wherein the hole extends through the layers (11a, 11b) of the stack (11);
selectively etching (93) from within the hole, in order to recess either the dielectric layers (11a) or the silicon-based layers (11b) so as to partially broaden the hole;
filling (94) a magnetic material into the etched hole to form a magnetic material channel (12), which has a first diameter (d1) where it extends through a silicon-based layer (11b) of the stack (11) and a second diameter (d2) where it extends through a dielectric layer (11a) of the stack (11),
wherein a plurality of stacked pinning sites defined by the plurality of layers (11a, 11b) of the stack (11) is formed in the magnetic material channel (12), each pinning site being configured to store one magnetic bit;
forming (95) a first metallic layer (13) on a first end of the magnetic material channel (12) and on the last layer of the stack (11);
forming (96) a magnetic tunnel junction, MTJ, (14) on the first metallic layer (13); and
forming (97) a first electrode (15) on the first metallic layer (13) at a distance to the MTJ (14);
wherein either the first metallic layer (13) is configured as a spin-orbit-torque, SOT, track, or the method (90) further comprises forming (98) a second metallic layer (16) configured as an SOT track and arranging a second end of the magnetic material channel (12) and the first layer of the stack (11) on the second metallic layer (16).

16. The method (90) of claim 15, further comprising depositing a liner (110) of SOT track material on the walls of the hole, before filling the magnetic material into the hole.

## Patentansprüche

1. Dreidimensionale, 3D, Magnetspeichervorrichtung (10), wobei die Magnetspeichervorrichtung (10) Folgendes umfasst:
einen Stapel (11), der eine Mehrzahl von dielektrischen Schichten (11a) und siliziumbasierten Schichten (11b) umfasst, die abwechselnd übereinander angeordnet sind;
einen Magnetmaterialkanal (12), der durch den Stapel (11) ausgebildet ist,
wobei sich der Magnetmaterialkanal (12) durch jede Schicht (11a, 11b) des Stapels (11) erstreckt,
wobei der Magnetmaterialkanal (12) dort, wo er sich durch eine siliziumbasierte Schicht (11b) erstreckt, einen ersten Durchmesser (d1) und dort, wo er sich durch eine dielektrische Schicht (11a) des Stapels (11) erstreckt, einen zweiten Durchmesser (d2) aufweist, und
wobei eine Mehrzahl von Verstiftungsstellen, die durch die Mehrzahl von Schichten (11a, 11b) des Stapels definiert ist, in dem Magnetmaterialkanal (12) ausgebildet ist, wobei jede Verstiftungsstelle dazu ausgelegt ist, ein magnetisches Bit zu speichern;
eine erste Metallschicht (13), die an einem ersten Ende des Magnetmaterialkanals (12) und auf der letzten Schicht des Stapels (11) angeordnet ist;
einen Magnettunnelübergang, MTJ, (14), der auf der ersten Metallschicht (13) angeordnet ist, und
eine erste Elektrode (15), die auf der ersten Metallschicht (13) in einem Abstand zum MTJ angeordnet ist;
wobei entweder die erste Metallschicht (13) als Spin-Orbit-Torque-Leiterbahn, SOT-Leiterbahn, ausgelegt ist, oder die Magnetspeichervorrichtung (10) eine zweite Metallschicht (16) umfasst, die als SOT-Leiterbahn ausgelegt ist, und ein zweites Ende des Magnetmaterialkanals (12) und die erste Schicht des Stapels (11) auf der zweiten Metallschicht (16) angeordnet sind.

2. 3D-Magnetspeichervorrichtung (10) nach Anspruch 1, ferner umfassend eine zweite Elektrode (41), die an oder direkt unter dem zweiten Ende des Magnetmaterialkanals (12) angeordnet ist.

3. 3D-Magnetspeichervorrichtung (10) nach Anspruch 1 oder 2, wobei der erste Durchmesser (d1) größer ist als der zweite Durchmesser (d2).

4. 3D-Magnetspeichervorrichtung (10) nach einem der Ansprüche 1 bis 3, wobei ein Verhältnis zwischen dem ersten Durchmesser (d1) und dem zweiten Durchmesser (d2) in einem Bereich von 1,1:1 bis 2:1 liegt.

5. 3D-Magnetspeichervorrichtung (10) nach einem der Ansprüche 1 bis 4, wobei eine Dicke der siliziumbasierten Schichten (11b) und der dielektrischen Schichten (11a) jeweils im Bereich von 5-150 nm liegt.

6. 3D-Magnetspeichervorrichtung (10) nach einem der Ansprüche 1 bis 5, wobei Übergänge zwischen dem ersten Durchmesser (d1) und dem zweiten Durchmesser (d2) mit Grenzflächen zwischen den abwechselnd angeordneten Schichten des Stapels (11) ausgerichtet sind.

7. 3D-Magnetspeichervorrichtung (10) nach einem der Ansprüche 1 bis 6, wobei:
die dielektrischen Schichten (11a) Siliziumoxidschichten sind und die siliziumbasierten Schichten (11b) Siliziumnitridschichten sind oder
die dielektrischen Schichten (11a) Siliziumschichten sind und die siliziumbasierten Schichten (11b) Silizium-Germanium-Schichten sind.

8. 3D-Magnetspeichervorrichtung (10) nach einem der Ansprüche 1 bis 7, wobei der Magnetmaterialkanal (12) aus einem von einem ferromagnetischen oder einem ferrimagnetischen Material hergestellt ist, beispielsweise aus Kobalt, Eisen, Nickel oder einer Legierung davon oder einem der ersteren zusätzlich zu Bor hergestellt ist.

9. 3D-Magnetspeichervorrichtung (10) nach einem der Ansprüche 1 bis 8, wobei mindestens eine von der ersten Metallschicht (13) und der zweiten Metallschicht (16) aus Tantalnitrid, Wolframnitrid, Wolfram, Tantal, Platin, Hafnium, Molybdän, Molybdännitrid oder ihren Legierungen hergestellt ist oder aus einem topologischen Isolator hergestellt ist.

10. 3D-Magnetspeichervorrichtung (10) nach einem der Ansprüche 1 bis 9, wobei der MTJ (14) direkt über dem ersten Ende des Magnetmaterialkanals (12) auf der ersten Metallschicht (13) angeordnet ist oder vom ersten Ende des Magnetmaterialkanals (12) versetzt angeordnet ist.

11. 3D-Magnetspeichervorrichtung (10) nach einem der Ansprüche 1 bis 10, wobei der MTJ (14) eine magnetische freie Schicht mit einer Koerzitivfeldstärke von gleich oder kleiner 20-40 MT oder einer Koerzitivfeldstärke in einem Bereich von 2-3 MT umfasst.

12. Verfahren (80) zum Betreiben der 3D-Magnetspeichervorrichtung (10) nach einem der Ansprüche 1 bis 10, wobei das Verfahren (80) mindestens eine der folgenden Operationen umfasst:
Schreiben (81) eines magnetischen Bits in den Magnetmaterialkanal (12) durch Durchleiten eines Stroms durch die SOT-Leiterbahn, wobei das magnetische Bit in die Verstiftungsstelle in dem Magnetmaterialkanal (12) geschrieben wird, der der SOT-Leiterbahn am nächsten ist;
Treiben (82) von magnetischen Bits entlang des Magnetmaterialkanals (12) von einer Verstiftungsstelle zur nächsten Verstiftungsstelle durch Durchleiten eines Stroms durch die erste Elektrode (15);
Auslesen (83) eines magnetischen Bits aus dem Magnetmaterialkanal (12) durch Durchleiten eines Stroms durch den MTJ (14) und dadurch Bestimmen eines Tunnelmagnetowiderstands, wobei das magnetische Bit ausgelesen wird, das in der Verstiftungsstelle in dem Magnetmaterialkanal (12) gespeichert ist, der dem MTJ (14) am nächsten ist.

13. Verfahren (80) nach Anspruch 12, wobei:
die Magnetspeichervorrichtung (10) die zweite Elektrode (41) umfasst und das Treiben der magnetischen Bits Senden des Stroms von der zweiten Elektrode (41) zur ersten Elektrode (15) umfasst; oder
die Magnetspeichervorrichtung (10) die zweite Elektrode (41) nicht umfasst, aber die zweite Metallschicht (16) umfasst, und das Treiben (82) der magnetischen Bits Senden des Stroms von der zweiten Metallschicht (16) zur ersten Elektrode (15) umfasst; oder
die Magnetspeichervorrichtung (10) die zweite Elektrode (41) umfasst und die erste Metallschicht (13) als SOT-Leiterbahn ausgelegt ist, und das Treiben (82) der magnetischen Bits Senden eines bipolaren Stroms von der zweiten Metallschicht (16) zur ersten Elektrode (15) umfasst.

14. Verfahren (80) nach Anspruch 12 oder 13, wobei beim Treiben (82) der im Magnetmaterialkanal (12) gespeicherten magnetischen Bits das magnetische Bit, das in der Verstiftungsstelle in dem Magnetmaterialkanal (12) gespeichert ist, der der ersten Metallschicht (13) am nächsten ist, zerstört wird und das Verfahren (80) ferner Folgendes umfasst:
erneutes Schreiben des zerstörten magnetischen Bits in den Magnetmaterialkanal (12) oder Speichern der Informationen, die dem zerstörten magnetischen Bit entsprechen, in einem Speicher.

15. Verfahren (90) zur Herstellung einer 3D-Magnetspeichervorrichtung (10), wobei das Verfahren (90) Folgendes umfasst:
Bilden (91) eines Stapels (11) einer Mehrzahl von dielektrischen Schichten (11a) und siliziumbasierten Schichten (11b), die abwechselnd übereinander angeordnet sind;
Bilden (92) eines Lochs durch den Stapel (11), wobei sich das Loch durch die Schichten (11a, 11b) des Stapels (11) erstreckt;
selektives Ätzen (93) von innerhalb des Lochs, um entweder die dielektrischen Schichten (11a) oder die siliziumbasierten Schichten (11b) zu vertiefen, um das Loch teilweise zu erweitern;
Füllen (94) eines magnetischen Materials in das geätzte Loch, um einen Magnetmaterialkanal (12) zu bilden, der dort, wo er sich durch eine siliziumbasierte Schicht (11b) des Stapels (11) erstreckt, einen ersten Durchmesser (d1) und dort, wo er sich durch eine dielektrische Schicht (11a) des Stapels (11) erstreckt, einen zweiten Durchmesser (d2) aufweist;
wobei eine Mehrzahl von gestapelten Verstiftungsstellen, die durch die Mehrzahl von Schichten (11a, 11b) des Stapels (11) definiert ist, in dem Magnetmaterialkanal (12) ausgebildet ist, wobei jede Verstiftungsstelle dazu ausgelegt ist, ein magnetisches Bit zu speichern;
Bilden (95) einer ersten Metallschicht (13) an einem ersten Ende des Magnetmaterialkanals (12) und auf der letzten Schicht des Stapels (11);
Bilden (96) eines Magnettunnelübergangs, MTJ, (14) auf der ersten Metallschicht (13) und
Bilden (97) einer ersten Elektrode (15) auf der ersten Metallschicht (13) in einem Abstand zum MTJ (14);
wobei entweder die erste Metallschicht (13) als Spin-Orbit-Torque-Leiterbahn, SOT-Leiterbahn, ausgelegt ist oder das Verfahren (90) ferner Bilden (98) einer zweiten Metallschicht (16), die als SOT-Bahn ausgelegt ist, und Anordnen eines zweiten Endes des Magnetmaterialkanals (12) und der ersten Schicht des Stapels (11) auf der zweiten Metallschicht (16) umfasst.

16. Verfahren (90) nach Anspruch 15, ferner umfassend Abscheiden einer Auskleidung (110) aus SOT-Leiterbahnmaterial auf die Wände des Lochs, bevor das magnetische Material in das Loch gefüllt wird.

## Revendications

1. Dispositif de mémoire magnétique tridimensionnel, 3D (10), le dispositif de mémoire magnétique (10) comprenant :
un empilement (11) comprenant une pluralité de couches diélectriques (11a) et de couches à base de silicium (11b), qui sont disposées en alternance les unes sur les autres ;
un canal de matériau magnétique (12) formé à travers l'empilement (11),
le canal de matériau magnétique (12) s'étendant à travers chaque couche (11a, 11b) de l'empilement (11),
le canal de matériau magnétique (12) ayant un premier diamètre (d1) à l'endroit où il s'étend à travers une couche à base de silicium (11b) et un deuxième diamètre (d2) à l'endroit où il s'étend à travers une couche diélectrique (11a) de l'empilement (11), et
une pluralité de sites d'ancrage définie par la pluralité de couches (11a, 11b) de l'empilement étant formée dans le canal de matériau magnétique (12), chaque site d'ancrage étant conçu pour stocker un bit magnétique ;
une première couche métallique (13) disposée sur une première extrémité du canal de matériau magnétique (12) et sur la dernière couche de l'empilement (11) ;
une jonction tunnel magnétique, MTJ (14), disposée sur la première couche métallique (13) ; et
une première électrode (15) disposée sur la première couche métallique (13) à une distance de la MTJ ;
dans lequel soit la première couche métallique (13) est conçue comme une piste à couple spin-orbite, SOT, soit le dispositif de mémoire magnétique (10) comprend une deuxième couche métallique (16) conçue comme une piste SOT, et une deuxième extrémité du canal de matériau magnétique (12) et la première couche de l'empilement (11) sont disposées sur la deuxième couche métallique (16).

2. Dispositif de mémoire magnétique 3D (10) de la revendication 1, comprenant en outre une deuxième électrode (41) disposée sur ou juste en dessous de la deuxième extrémité du canal de matériau magnétique (12).

3. Dispositif de mémoire magnétique 3D (10) de la revendication 1 ou 2, dans lequel le premier diamètre (d1) est plus grand que le deuxième diamètre (d2).

4. Dispositif de mémoire magnétique 3D (10) d'une des revendications 1 à 3, dans lequel un rapport entre le premier diamètre (d1) et le deuxième diamètre (d2) est compris entre 1,1/1 et 2/1.

5. Dispositif de mémoire magnétique 3D (10) d'une des revendications 1 à 4, dans lequel une épaisseur des couches à base de silicium (11b) et des couches diélectriques (11a) est respectivement comprise entre 5 et 150 nm.

6. Dispositif de mémoire magnétique 3D (10) d'une des revendications 1 à 5, dans lequel des transitions entre le premier diamètre (d1) et le deuxième diamètre (d2) sont alignées avec des interfaces entre les couches disposées en alternance de l'empilement (11).

7. Dispositif de mémoire magnétique 3D (10) d'une des revendications 1 à 6, dans lequel :
les couches diélectriques (11a) sont des couches d'oxyde de silicium et les couches à base de silicium (11b) sont des couches de nitrure de silicium ; ou
les couches diélectriques (11a) sont des couches de silicium et les couches à base de silicium (11b) sont des couches de silicium-germanium.

8. Dispositif de mémoire magnétique 3D (10) d'une des revendications 1 à 7, dans lequel le canal de matériau magnétique (12) est constitué d'un matériau ferromagnétique ou ferrimagnétique, par exemple est constitué de cobalt, de fer, de nickel ou d'un alliage de ceux-ci, ou de n'importe lequel de ces matériaux en plus de bore.

9. Dispositif de mémoire magnétique 3D (10) d'une des revendications 1 à 8, dans lequel la première couche métallique (13) et/ou la deuxième couche métallique (16) sont constituées de nitrure de tantale, de nitrure de tungstène, de tungstène, de tantale, de platine, d'hafnium, de molybdène, de nitrure de molybdène ou d'alliages de ceux-ci, ou sont constituées d'un isolant topologique.

10. Dispositif de mémoire magnétique 3D (10) d'une des revendications 1 à 9, dans lequel la MTJ (14) est disposée juste au-dessus de la première extrémité du canal de matériau magnétique (12) sur la première couche métallique (13), ou est disposée de façon décalée par rapport à la première extrémité du canal de matériau magnétique (12).

11. Dispositif de mémoire magnétique 3D (10) d'une des revendications 1 à 10, dans lequel la MTJ (14) comprend une couche magnétique libre ayant une coercivité égale ou inférieure à 20-40 mT, ou une coercivité comprise entre 2 et 3 mT.

12. Procédé (80) de fonctionnement du dispositif de mémoire magnétique 3D (10) de l'une quelconque des revendications 1 à 10, le procédé (80) comprenant au moins une des opérations suivantes :
écriture (81) d'un bit magnétique à l'intérieur du canal de matériau magnétique (12) par passage d'un courant à travers la piste SOT, le bit magnétique étant écrit à l'intérieur du site d'ancrage dans le canal de matériau magnétique (12) qui est le plus proche de la piste SOT ;
poussée (82) de bits magnétiques le long du canal de matériau magnétique (12) d'un site d'ancrage au site d'ancrage suivant par passage d'un courant à travers la première électrode (15) ;
lecture (83) d'un bit magnétique depuis le canal de matériau magnétique (12) par passage d'un courant à travers la MTJ (14), et ainsi détermination d'une magnétorésistance tunnel, le bit magnétique stocké dans le site d'ancrage dans le canal de matériau magnétique (12) qui est le plus proche de la MTJ (14) étant lu.

13. Procédé (80) de la revendication 12, dans lequel :
le dispositif de mémoire magnétique (10) comprend la deuxième électrode (41), et la poussée des bits magnétiques comprend l'envoi du courant de la deuxième électrode (41) à la première électrode (15) ; ou
le dispositif de mémoire magnétique (10) ne comprend pas la deuxième électrode (41), mais comprend la deuxième couche métallique (16), et la poussée (82) des bits magnétiques comprend l'envoi du courant de la deuxième couche métallique (16) à la première électrode (15) ; ou
le dispositif de mémoire magnétique (10) comprend la deuxième électrode (41) et la première couche métallique (13) est conçue comme la piste SOT, et la poussée (82) des bits magnétiques comprend l'envoi d'un courant bipolaire de la deuxième couche métallique (16) à la première électrode (15).

14. Procédé (80) de la revendication 12 ou 13 dans lequel, lors de la poussée (82) des bits magnétiques stockés dans le canal de matériau magnétique (12), le bit magnétique stocké dans le site d'ancrage dans le canal de matériau magnétique (12) qui est le plus proche de la première couche métallique (13) est détruit, et le procédé (80) comprend en outre :
la réécriture du bit magnétique détruit à l'intérieur du canal de matériau magnétique (12) ou le stockage des informations correspondant au bit magnétique détruit dans une mémoire.

15. Procédé (90) de fabrication d'un dispositif de mémoire magnétique 3D (10), le procédé (90) comprenant :
la formation (91) d'un empilement (11) d'une pluralité de couches diélectriques (11a) et de couches à base de silicium (11b), qui sont disposées en alternance les unes sur les autres ;
la formation (92) d'un trou à travers l'empilement (11), le trou s'étendant à travers les couches (11a, 11b) de l'empilement (11) ;
une gravure sélective (93) depuis l'intérieur du trou afin d'évider les couches diélectriques (11a) ou les couches à base de silicium (11b) de manière à élargir partiellement le trou ;
le remplissage (94) du trou gravé avec un matériau magnétique pour former un canal de matériau magnétique (12), qui a un premier diamètre (d1) à l'endroit où il s'étend à travers une couche à base de silicium (11b) de l'empilement (11) et un deuxième diamètre (d2) à l'endroit où il s'étend à travers une couche diélectrique (11a) de l'empilement (11),
une pluralité de sites d'ancrage empilés définie par la pluralité de couches (11a, 11b) de l'empilement (11) étant formée dans le canal de matériau magnétique (12), chaque site d'ancrage étant conçu pour stocker un bit magnétique ;
la formation (95) d'une première couche métallique (13) sur une première extrémité du canal de matériau magnétique (12) et sur la dernière couche de l'empilement (11) ;
la formation (96) d'une jonction tunnel magnétique, MTJ (14), sur la première couche métallique (13) ; et
la formation (97) d'une première électrode (15) sur la première couche métallique (13) à une distance de la MTJ (14) ;
dans lequel soit la première couche métallique (13) est conçue comme une piste à couple spin-orbite, SOT, soit le procédé (90) comprend en outre la formation (98) d'une deuxième couche métallique (16) conçue comme une piste SOT et la disposition d'une deuxième extrémité du canal de matériau magnétique (12) et de la première couche de l'empilement (11) sur la deuxième couche métallique (16).

16. Procédé (90) de la revendication 15, comprenant en outre le dépôt d'un revêtement (110) de matériau de piste SOT sur les parois du trou, avant le remplissage du trou avec le matériau magnétique.
